(19) Europäisches Patentamt
European Patent Office
Office européen des brevets

(11) **EP 3 354 374 A1**

(12) **EUROPEAN PATENT APPLICATION**

(43) Date of publication:
**01.08.2018 Bulletin 2018/31**

(51) Int Cl.:
**B22D 17/32** *(2006.01)* **B22D 17/10** *(2006.01)*
**B22D 17/22** *(2006.01)*

(21) Application number: **18153493.4**

(22) Date of filing: **25.01.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **27.01.2017 JP 2017013217**

(71) Applicant: **TOYOTA JIDOSHA KABUSHIKI KAISHA**
**Toyota-shi, Aichi-ken, 471-8571 (JP)**

(72) Inventors:
• **TSUCHIYA, Shoichi**
**TOYOTA-SHI, AICHI-KEN, 471-8571 (JP)**
• **IKUTA, Hiroyuki**
**TOYOTA-SHI, AICHI-KEN, 471-8571 (JP)**

(74) Representative: **Cabinet Beau de Loménie**
**158, rue de l'Université**
**75340 Paris Cedex 07 (FR)**

(54) **ANALYSIS METHOD FOR ANALYZING DEFORMATION OF CASTING IN DIE CASTING PROCESS**

(57) An analysis method for analyzing deformation of a casting in a die casting process includes obtaining a first die frictional stress exerted by a first die on the casting in a mold opening step, and calculating deformation of the casting in the mold opening step using the first die frictional stress. A predetermined frictional coefficient function is selected from a plurality of frictional coefficient functions based on casting conditions and lubrication conditions. A frictional coefficient at each portion of the casting is output by inputting a temperature of a contact surface between the casting and the first die and a contact surface pressure therebetween into the selected predetermined frictional coefficient function. The first die frictional stress acting on each portion of the casting is obtained by multiplying the contact surface pressure and the frictional coefficient.

FIG. 2

EP 3 354 374 A1

**Description**

1. Field of the Invention

The present invention relates to an analysis method for analyzing deformation of a casting in a die casting process.

2. Description of Related Art

Japanese Patent Application Publication No. 07-009522 discloses an injection molding process simulation method that involves sequentially conducting analyses of filling, fluid flow under hold pressure, and cooling in an injection molding process, and calculating a temperature change of a molding material undergoing the injection molding process etc., and thus calculating the amount of shape deformation of a final product etc. In the cooling analysis, temperature boundary conditions are changed according to a state of contact between a surface of a molding and a surface of a mold. This injection molding process simulation method can be used to obtain a distribution of stress acting on a part of a product, and estimate mold release resistance up to mold opening based on this stress distribution, the area of a part of the product in contact with the mold, and a coefficient of friction between the product and the mold.

SUMMARY OF THE INVENTION

The present inventors have conceived of applying the method disclosed by JP 07-009522 A to analyzing melt flow, a mold temperature distribution, and casting solidification in a die casting process, and thereby calculating deformation of a casting after the casting is released from a mold. We have found room for improvement in the accuracy of such an analysis of deformation of a casting after its release from a mold.

An analysis method for analyzing deformation of a casting in a die casting process according to the present invention improves the accuracy of an analysis of casting deformation.

An aspect of the present invention relates to an analysis method for analyzing deformation of a casting in a die casting process including: a step of closing a mold by pressing a second die against a first die, and injecting molten metal into cavities of the first die and the second die and solidifying the molten metal to form a casting inside the cavities; and a mold opening step of opening the mold by separating the second die from the first die with the casting held in the second die. An aspect of the present invention includes: obtaining a first die frictional stress exerted by the first die on the casting in the mold opening step, and calculating deformation of the casting in the mold opening step using the first die frictional stress. A predetermined frictional coefficient function from a plurality of different frictional coefficient functions based on casting conditions and lubrication conditions is selected, and a frictional coefficient at each portion of the casting is output by inputting a temperature of a contact surface between the casting and the first die and a contact surface pressure between the casting and the first die into the selected predetermined frictional coefficient function; and then the first die frictional stress acting on each portion of the casting is calculated by multiplying the contact surface pressure exerted by the casting on the first die and the frictional coefficient. According to this configuration, the first die frictional stress exerted by the first die on the casting during mold opening can be taken into account in analyzing deformation of the casting. The value of the first die frictional stress varies according to the casting conditions, the lubrication conditions, the temperature of the contact surface between the casting and first die, and the contact surface pressure between the casting and the first die, and agrees with actual frictional stress in an actual test of deformation of a casting in a die casting process. Therefore, the accuracy of an analysis of casting deformation can be improved.

In the mold opening step, the frictional coefficient may be a static frictional coefficient from a time point at which the mold opening is started until immediately before a time point at which the second die is separated from the first die, and the frictional coefficient may be a dynamic frictional coefficient from the time point at which the second die and the first die are separated from each other until a time point at which the casting is separated from the second die. According to this configuration, the first die frictional stress can be obtained in the mold opening step by using either a static frictional coefficient $\mu 0$ or a dynamic frictional coefficient $\mu l$ depending on the time point in the step. Thus, the value of the first die frictional stress agrees with actual frictional stress in an actual test of deformation of a casting in a die casting process, so that the accuracy of an analysis of casting deformation can be further improved.

The amount of movement that the casting moves in the mold opening step from the time point at which the mold opening is started until the time point at which the casting is separated from the second die may be obtained based on a draft of the first die and the amounts of elastic deformation of the first die and the casting, and the amounts of elastic deformation of the first die and the casting may be obtained using the moduli of elasticity of the first die and the casting, the modulus of elasticity of the first die varying with a temperature of the first die, the modulus of elasticity of the casting varying with a temperature of the casting. According to this configuration, the amounts of elastic deformation of the first die and the casting can be obtained using the moduli of elasticity of the first die and the casting according to their respective temperatures, and moreover, the amount of movement that the casting moves in the mold opening step from the time point at which the mold opening is started until the time point at which the casting is separated from the second die can be obtained. Thus, the value of the first die frictional stress agrees with actual frictional stress in an actual test of deformation of a casting in a die casting process, so that the accuracy of an analysis of casting deformation can be further improved.

The die casting process may further include a mold releasing step of releasing the casting from the second die after the mold opening step, and the analysis method may further include obtaining a second die frictional stress exerted by the second die on the casting when an ejector pin is thrust out of the cavity of the second die in the mold releasing step, and calculating deformation of the casting in the mold releasing step using the second die frictional stress. According to this configuration, the second die frictional stress exerted by the second die on the casting can be taken into account in obtaining deformation of the casting in the mold releasing step. The accuracy of an analysis of casting deformation can be further improved by taking into account both the obtained casting deformation in the mold releasing step and the casting deformation in the mold opening step.

The analysis method for analyzing deformation of a casting in a die casting process according to the present invention can improve the accuracy of an analysis of casting deformation.

BRIEF DESCRIPTION OF THE DRAWINGS

Features, advantages, and technical and industrial significance of exemplary embodiments of the invention will be described below with reference to the accompanying drawings, in which like numerals denote like elements, and wherein:

FIG. 1 is a flowchart showing a method for analyzing deformation of a casting in a die casting process according to the embodiment;
FIG. 2 is the flowchart showing the method for analyzing deformation of a casting in a die casting process, and a block diagram showing calculation items, according to the embodiment;
FIG. 3 is a schematic view showing an analysis model that is used in the method for analyzing deformation of a casting in a die casting process according to the embodiment;
FIG. 4 is a main part of a table showing casting conditions and lubrication conditions that is used in the method for analyzing deformation of a casting in a die casting process according to the embodiment;
FIG. 5 is a graph showing a frictional coefficient $\mu$ relative to a contact surface temperature and a contact surface pressure;
FIG. 6 is a schematic view showing a boundary surface between a casting and a mold in a mold opening step;
FIG. 7 is a schematic view showing the boundary surface between the casting and the mold in the mold opening step;
FIG. 8 is a schematic view showing the boundary surface between the casting and the mold in the mold opening step; and
FIG. 9 is a graph showing a specific example of stress and a frictional coefficient relative to the amount of movement of the casting.

DETAILED DESCRIPTION OF EMBODIMENTS

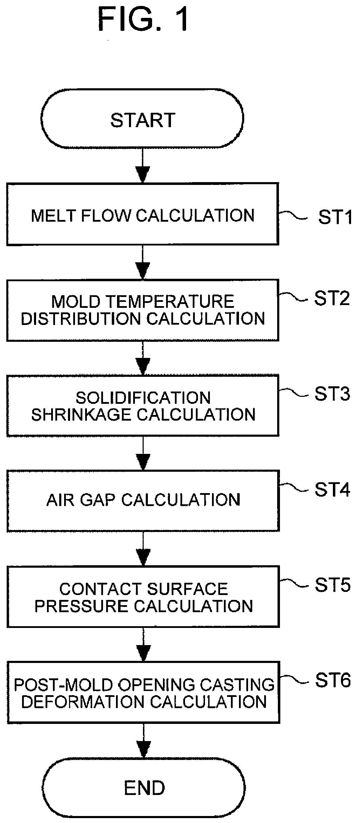

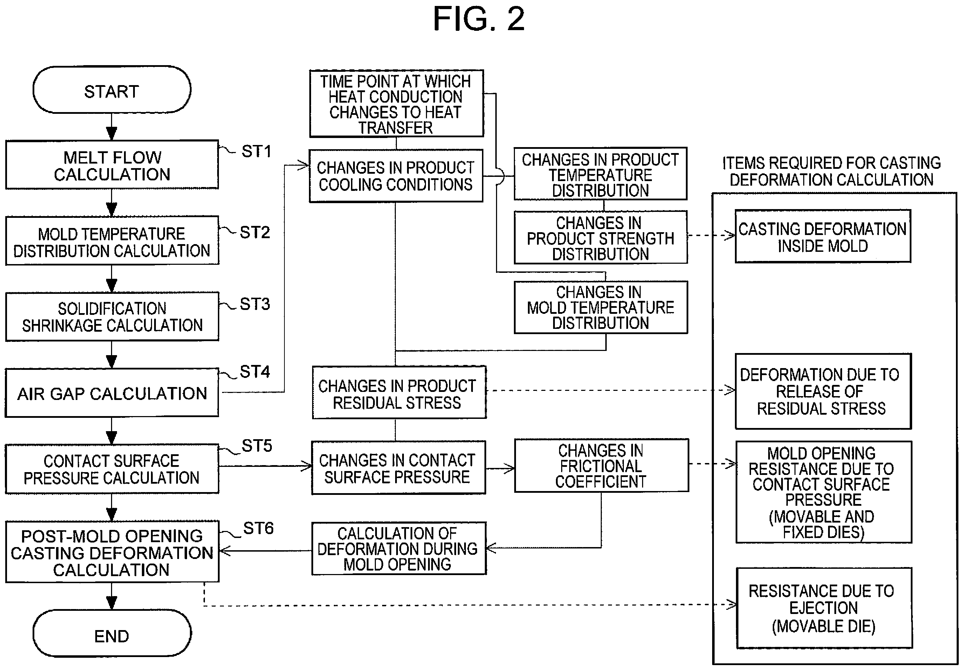

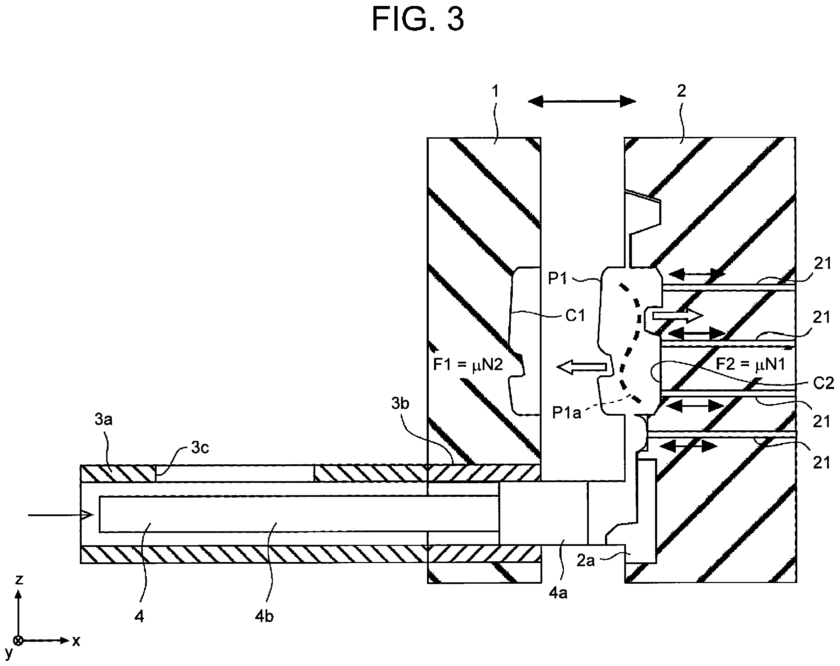

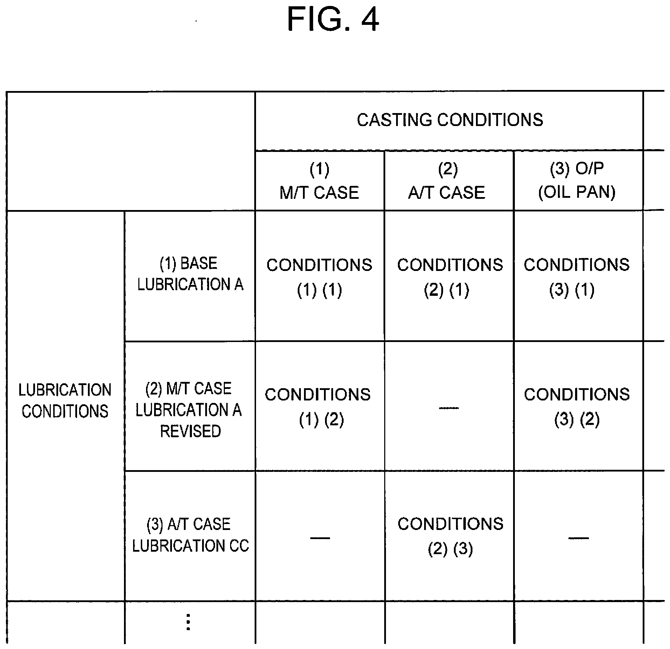

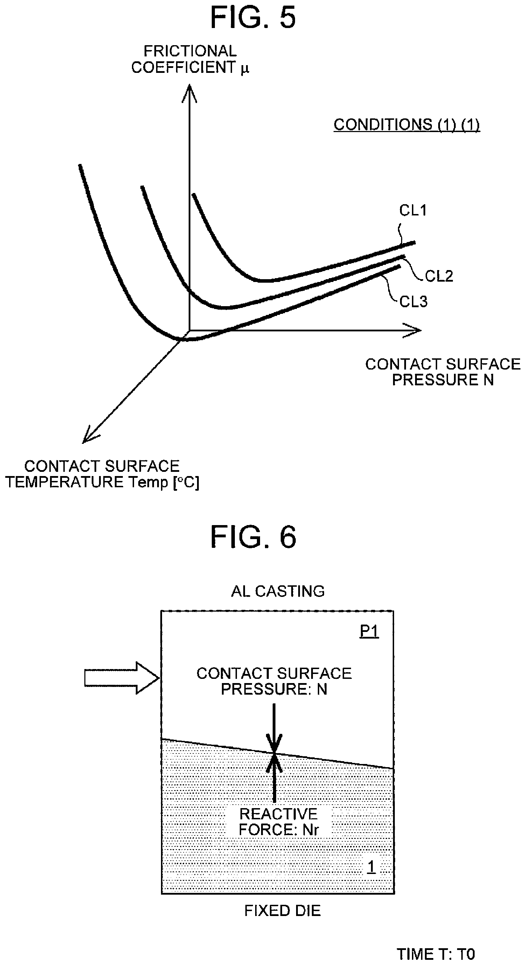

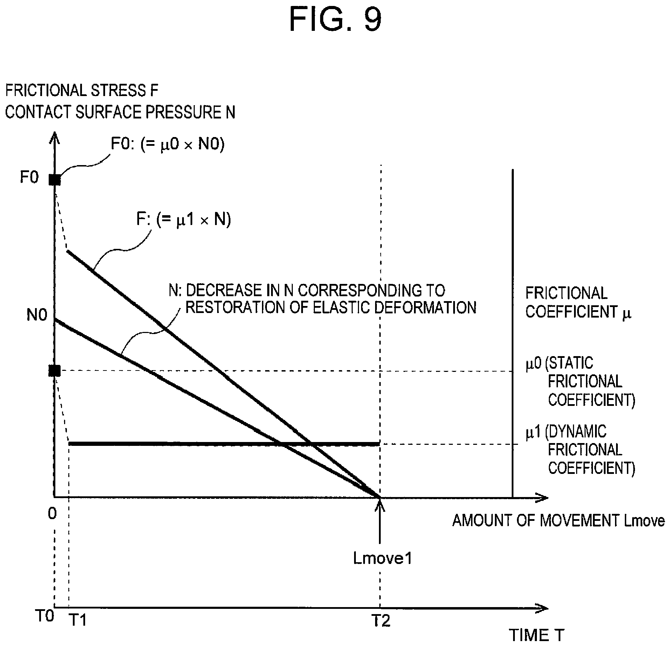

A method for analyzing deformation of a casting in a die casting process according to the embodiment will be described with reference to FIG. 1 to FIG. 9. FIG. 1 is a flowchart showing the method for analyzing deformation of a casting in a die casting process according to the embodiment. FIG. 2 is the flowchart showing the method for analyzing deformation of a casting in a die casting process, and a block diagram showing calculation items, according to the embodiment. FIG. 3 is a schematic view showing an analysis model that is used in the method for analyzing deformation of a casting in a die casting process according to the embodiment. FIG. 4 is a main part of a table showing casting conditions and lubrication conditions that is used in the method for analyzing deformation of a casting in a die casting process according to the embodiment. FIG. 5 is a graph showing a frictional coefficient $\mu$ relative to a contact surface temperature and a contact surface pressure. FIG. 6 to FIG. 8 are schematic views showing a boundary surface between a casting and a mold in a mold opening step. FIG. 9 is a graph showing a specific example of stress and a frictional coefficient relative to the amount of movement of the casting.

In the method for analyzing deformation of a casting in a die casting process according to the embodiment, casting deformation is calculated by computer aided engineering (CAE) using the die casting process shown in FIG. 3 as a model. A wide variety of numerical analysis techniques can be used in this analysis method. For example, various methods including a finite volume method, finite difference method, finite element method, and particle method can be used in a melt flow analysis. A plurality of types of these numerical analysis techniques may be used in combination as necessary. This model includes molten metal (not shown), a casting PI, a fixed die 1 (a first die), a movable die 2 (a second die), a sleeve 3, and a plunger 4. In the die casting process shown in FIG. 3, the casting P1 is formed by solidifying the molten metal (not shown) using the fixed die 1, the movable die 2, the sleeve 3, and the plunger 4. For example, a die casting aluminum alloy can be used for the molten metal and the casting P1. The fixed die 1 and the movable die 2 are installed in a casting machine (not shown) and their respective actions are controlled. The sleeve 3 and the plunger 4 are components of this casting machine. The sleeve 3 is held in a predetermined position, and the plunger 4 is held so as to be able to reciprocate inside the sleeve 3 in an axial direction of the sleeve 3.

The die casting process will be specifically described. First, the mold is closed by pressing the movable die 2 against the fixed die 1 into close contact. A cavity C1 of the fixed die 1 and a cavity C2 of the movable die 2 are butted together, and thus the cavities C1, C2 having the same or almost the same shape as the casting P1 are formed. The molten metal is poured through a molten metal inlet 3c of the sleeve 3, and the plunger 4 is pushed in toward the movable die 2, and thus the molten metal is injected to fill the cavities C1, C2. After filling, a predetermined pressure is applied to the molten metal, and the molten metal is solidified in this state. When the molten metal has solidified and the casting P1 has been formed, the volume of the casting P1 has become smaller than the volume of the molten metal due to solidification shrinkage and thermal shrinkage. As a result of the solidification shrinkage and the thermal shrinkage, an air gap (clearance) is left at an interface between the casting P1 and the cavity C1 of the fixed die 1 and at an interface between the casting P1 and the cavity C2 of the movable die 2. The mold is opened by separating the movable die 2 from the fixed die 1 with the casting P1 held in the movable die 2. The casting P1 is released from the movable die 2 by pushing the casting P1 out of the cavity C2 of the movable die 2 using ejector pins 21 that can be thrust out of the cavity C2 toward an outside of the movable die 2, in other words, toward the fixed die 1. Thus, the casting P1 is formed.

First, the melt flow analysis is conducted (melt flow calculation step ST1). Specifically, first, the mold is closed by pressing the movable die 2 against the fixed die 1. The flow of the molten metal from when the molten metal is poured through the molten metal inlet 3c of the sleeve 3 with the mold closed until when the molten metal is injected to fill the cavities C1, C2 as the plunger 4 is pushed in toward the movable die 2 is calculated.

Next, temperature distributions in the fixed die 1 and the movable die 2 are calculated (mold temperature distribution calculation step ST2). Specifically, the temperature distributions in the fixed die 1 and the movable die 2 from a time point at which the molten metal is poured through the molten metal inlet 3c of the sleeve 3 until a time point at which the molten metal is injected to fill the cavities C1, C2 and solidified under pressure are calculated.

Next, solidification shrinkage of the molten metal is calculated (solidification shrinkage calculation step ST3). Specifically, solidification shrinkage resulting when the molten metal solidifies in the cavities of the fixed die 1 and the movable die 2 and the casting P1 is formed is calculated.

Next, the air gap is calculated (air gap calculation step ST4). As described above, the air gap (clearance) is left at the interface between the casting P1 and the cavity C1 of the fixed die 1 and at the interface between the casting P1 and the cavity C2 of the movable die 2, as the molten metal and the casting P1 undergo thermal shrinkage and solidification shrinkage upon solidification of the molten metal inside the cavities C1, C2 of the fixed die 1 and the movable die 2. For example, the position, size, and range of this air gap, and a time point at which it occurs are calculated. Specifically, the form of heat migration at the interface between the molten metal or the casting P1 and the fixed die 1 and the form of heat migration at the interface between the molten metal or the casting P1 and the movable die 2 change from heat conduction to heat transfer. A time point at which this change in the form of heat migration occurs is calculated (see FIG. 2).

Next, changes in product cooling conditions, changes in a product temperature distribution, and changes in a product strength distribution are calculated in the order mentioned based on the result of the above air gap calculation, and deformation of the casting P1 inside the fixed die 1 and the movable die 2 (see FIG. 2), for example, the amount of deformation at each time point and each portion of the casting P1 is calculated. Next, changes in the mold temperature distribution that are changes in the temperature distributions in the fixed die 1 and the movable die 2 are calculated based on the time point at which the form of heat migration changes. Changes in product residual stress are calculated using the calculated changes in the mold temperature distribution and the above-mentioned changes in the product cooling conditions. Thus, the amount of deformation due to release of residual stress (see FIG. 2) can be obtained.

Next, a contact surface pressure N is calculated based on the residual stress (contact surface pressure calculation step ST5). The contact surface pressure N is a pressure with which each portion of the casting P1 presses each contact portion of the cavity C1 of the fixed die 1 and the cavity C2 of the movable die 2.

As can be seen by referring to the following Formula 1, the contact surface pressure N may be represented by a function f2 of an amount of movement Lmove and a contact surface temperature Temp:

$$N = f2 \, (Lmove, \, Temp) \cdots (Formula \, 1)$$

Finally, casting deformation after mold opening is calculated (post-mold opening casting deformation calculation step ST6).

First, in the mold opening step, deformation of the casting P1 from time point T0 at which mold opening is started until time point T2 at which the casting P1 is separated from the fixed die 1 is obtained using a fixed die frictional stress F, a temperature distribution in the casting P1, and a product strength distribution in the casting P1 (mold opening step-caused casting deformation calculation step ST61).

The relation among the fixed die frictional stress F, the frictional coefficient $\mu$, and the contact surface pressure N satisfies the following Formula 2:

$$F = \mu \times N \cdots \text{(Formula 2)}$$

As shown in FIG. 9, the relation among a fixed die frictional stress F0, a frictional coefficient $\mu 0$, and a contact surface pressure N0 when the amount of movement Lmove is zero satisfies the following Formula 2A:

$$F0 = \mu 0 \times N0 \cdots \text{(Formula 2A)}$$

The relation among the fixed die frictional stress F, a frictional coefficient $\mu l$, and the contact surface pressure N when the amount of movement Lmove is larger than zero satisfies the following Formula 2B:

$$F = \mu 1 \times N \cdots \text{(Formula 2B)}$$

Frictional Coefficient $\mu$

Here, the frictional coefficient $\mu$ is obtained. Specifically, first, casting conditions and lubrication conditions are determined, and thereby a frictional coefficient function is selected. A plurality of different types of frictional coefficient functions are obtained in advance by conducting a casting experiment under predetermined casting conditions and predetermined lubrication conditions. For each casting condition and each lubrication condition, the frictional coefficient functions include a frictional coefficient function f0 for a static frictional coefficient and a frictional coefficient function fl for a dynamic frictional coefficient. Input variables of the frictional coefficient function are the contact surface temperature Temp and the contact surface pressure N, and an output variable thereof is the frictional coefficient $\mu$. In other words, when the contact surface temperature Temp and the contact surface pressure N are input into the frictional coefficient function, this frictional coefficient function outputs the frictional coefficient $\mu$. More specifically, as shown in FIG. 4, various manufacturing conditions including the casting conditions and the lubrication conditions are selected. The casting conditions and the lubrication conditions are determined in advance according to a product to be manufactured. For example, the casting conditions shown in FIG. 4 include (1) M/T (manual transmission) case, (2) A/T (automatic transmission) case, and (3) O/P (oil pan). When these items (1) to (3) are determined, the casting conditions shown in FIG. 4 are specifically the material of the mold, the surface material of the mold, the surface roughness of the mold, the material of an alloy composing the casting, the surface state of the casting, the degree of vacuum, the atmosphere, etc. More specifically, the casting conditions are the modulus of elasticity and the plastic flow stress of the mold and those of the alloy composing the casting, a shape imparted from a surface of the mold to the casting by casting, etc. The moduli of elasticity here may respectively vary according to the temperatures of the mold and the alloy.

The lubrication conditions shown in FIG. 4 include (1) BASE lubrication A, (2) M/T (manual transmission) case lubrication A revised, and (3) A/T (automatic transmission) case lubrication CC. The lubrication conditions shown in FIG. 4 are, for example, the type of a mold release agent, the dilution ratio of the mold release agent, the amount of application of the mold release agent, and dryness. The dryness refers to whether water remains on a surface of the mold.

For example, when the condition (1) (1) is determined, the frictional coefficient functions f0, fl are selected. As shown in FIG. 5, the frictional coefficient functions f0, fl are functions that have the contact surface temperature Temp and the contact surface pressure N as input variables and the frictional coefficient $\mu$ as an output variable. Curves CL1 to CL3 shown in FIG. 5 each represent changes in the frictional coefficient $\mu$ in the case where the contact surface temperature Temp is at a predetermined value and the contact surface pressure N is within a predetermined range, and these curves are a part of a curve of the frictional coefficient function f1 showing the value of the frictional coefficient $\mu$ that is the output variable thereof.

As shown in FIG. 6, at time point T0 at which mold opening is started or at time point T0 immediately before mold opening, each portion of the casting P1 presses each portion of the fixed die 1 with the contact surface pressure N, while each portion of the fixed die 1 exerts a reactive force Nr on each portion of the casting P1 in reaction to the contact surface pressure N of the casting P1. The casting P1 and the fixed die 1 are pressing each other and neither moves. A static frictional coefficient $\mu0$ is used as the coefficient of friction between the casting P1 and the fixed die 1, from time point T0 at which mold opening is started until immediately before time point T1 immediately after the start, i.e., time point T1 at which the movable die 2 (see FIG. 3) is released from close contact with the fixed die 1 and separated from the fixed die 1. The contact surface temperature Temp and the contact surface pressure N at each portion are input into the frictional coefficient function f0 for the static frictional coefficient, and the corresponding static frictional coefficient $\mu0$ at that portion is output.

At time point T1 immediately after mold opening is started, the fixed die 1 tries to pull the casting P1 with a fixed die frictional stress F1, but the movable die 2 pulls the casting P1 with a force F2 larger than the fixed die frictional stress F1. Thus, the casting P1 is held in the movable die 2 and pulled in a direction away from the fixed die 1, so that the casting P1 moves. Although the casting P1 moves relative to the fixed die 1, both the casting P1 and the fixed die 1 undergo elastic deformation and press each other while in contact with each other. A dynamic frictional coefficient $\mu$l is used as the coefficient of friction between the casting P1 and the fixed die 1, from time point T1 at which the movable die 2 (see FIG. 3) is released from close contact with the fixed die 1 and separated from the fixed die 1 until time point T2 at which the casting P1 is released from close contact with the fixed die 1 and separated from the fixed die 1. The contact surface temperature Temp and the contact surface pressure N at each portion are input into the frictional coefficient function fl for the dynamic frictional coefficient, and the corresponding dynamic frictional coefficient $\mu$l at that portion is output.

Thus, the static frictional coefficient $\mu0$ and the dynamic frictional coefficient $\mu$l are respectively represented by the following Formulae 3 and 4:

$$\mu0 = f0\ (N,\ Temp) \cdots (Formula\ 3)$$

$$\mu1 = f1\ (N,\ Temp) \cdots (Formula\ 4)$$

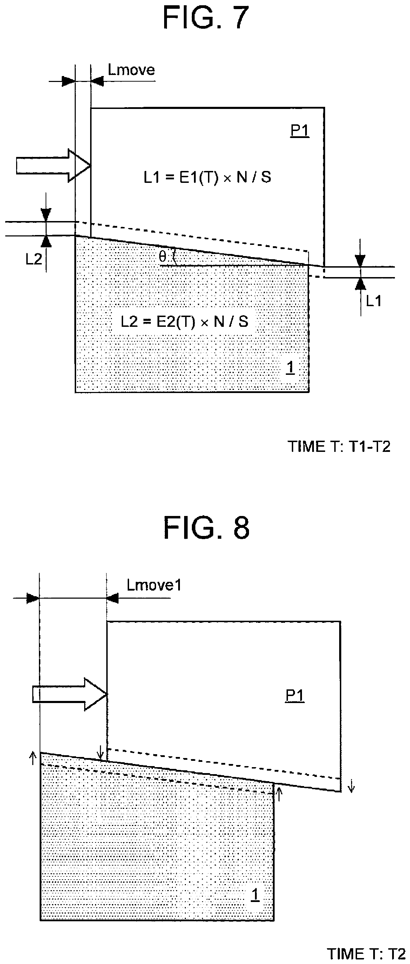

Next, a method of obtaining the length of time from time point T0 at which mold opening is started until time point T2 at which the casting P1 is released from close contact with the fixed die 1 and separated from the fixed die 1, and an amount of movement Lmovel of the casting P1 from time point T0 to time point T2, based on an amount of elastic deformation L1 of the casting P1 and an amount of elastic deformation L2 of the fixed die 1 will be described. As shown in FIG. 7, the relation among the amount of elastic deformation L1 of the casting PI, a modulus of elasticity E1 (T) of the casting PI, the contact surface pressure N, and a contact area S satisfies the following Formula 5. The modulus of elasticity E1 is a function having a temperature T of the casting P1 as an input variable:

$$L1 = E1\ (T) \times N\ /\ S \cdots (Formula\ 5)$$

The relation among the amount of elastic deformation L2 of the fixed die 1, a modulus of elasticity E2 (T) of the fixed die 1, the contact surface pressure N, and the contact area S satisfies the following Formula 6. The modulus of elasticity E2 is a function having a temperature T of the fixed die 1 as an input variable:

$$L2 = E2\ (T) \times N\ /\ S \cdots (Formula\ 6)$$

Using the above Formulae 5 and 6, the amount of elastic deformation L1 of the casting P1 and the amount of elastic deformation L2 of the fixed die 1 are obtained.

As shown in FIG. 8, from time point T0 at which mold opening is started, the casting P1 is pulled in the direction away from the fixed die 1, which increases the amount of movement Lmove of the casting P1. The amount of movement Lmove reaches the predetermined amount of movement Lmovel. Here, both the amount of elastic deformation L1 of the casting P1 and the amount of elastic deformation L2 of the fixed die 1 decrease to substantially zero. The casting P1 and the fixed die 1 are merely in contact with each other, or are slightly separated from each other, without pressing each other. The relation among the amount of movement Lmovel (see FIG. 9), the amount of elastic deformation L1 of the casting PI, the amount of elastic deformation L2 of the fixed die 1, and a draft $\theta$ of the fixed die 1 (see FIG. 7) satisfies the following Formula 7. The amount of movement Lmovel can be obtained using Formula 7.

$$Lmove1 = (L1 + L2) / \tan\theta \cdots \text{(Formula 7)}$$

The relation among the amount of movement Lmove1, a velocity V2 of the movable die 2, and a length of time T02 from time point T0 to time point T2 described above satisfies the following Formula 8. The length of time T02 can be obtained using Formula 8.

$$T02 = Lmove1 / V2 \cdots \text{(Formula 8)}$$

The frictional stress F exerted by the fixed die 1 on a predetermined portion of the casting P1 during mold opening can be obtained by multiplying the frictional coefficients $\mu0$, $\mu l$ and the contact surface pressure N at the predetermined portion. The frictional stress F is a mold opening resistance due to the contact surface pressure of the fixed die 1 (see FIG. 2). The contact surface pressure N tends to decrease as the amount of movement Lmove increases. A specific example of the contact surface pressure N is a linear function that has the amount of movement Lmove as a variable and has a negative slope. For example, when the amount of movement Lmove is zero and the contact surface pressure N is N0, a specific example of the contact surface pressure N is represented by the following Formula 9:

$$N = N0 - (N0 / Lmove1) \times Lmove \cdots \text{(Formula 9)}$$

Here, FIG. 9 shows a specific example of the frictional coefficient $\mu$, the fixed die frictional stress F, and the contact surface pressure N relative to the amount of movement Lmove at a predetermined portion of the casting P1.

The die casting process may further include a mold releasing step of releasing the casting P1 held in the movable die 2 from the movable die 2 after the mold opening step. In this mold releasing step, the casting P1 is released from the movable die 2 by pushing out the casting P1 using the ejector pins 21 (see FIG. 3) that can be thrust out of the cavity C2 of the movable die 2. In the mold releasing step, as necessary, deformation of the casting P1 from time point T2 at which the casting P1 is separated from the fixed die 1 until a time point at which the casting P1 is released from the movable die 2 may be obtained using a movable die frictional stress, the temperature distribution in the casting PI, and the product strength distribution in the casting P1 (mold releasing step-caused casting deformation calculation step ST62). In this step, for example, the movable die frictional stress exerted by the movable die 2 on the casting P1 through the ejector pins 21 can be calculated in the same manner as the fixed die frictional stress F1 in the mold opening step-caused casting deformation calculation step ST61. Casting deformation in the mold releasing step can be obtained based on this calculated movable die frictional stress along with the deformation of the casting P1 due to the fixed die frictional stress F etc. and the deformation of the casting P1 inside the mold (see FIG. 2), and the amount of deformation due to release of residual stress (see FIG. 2) that are obtained in the air gap calculation step ST4 and the contact surface pressure calculation step ST5. Casting deformation after mold opening may be obtained based on the casting deformation in the mold opening step and the casting deformation in the mold releasing step.

Thus, deformation of the casting P1 after mold opening can be calculated. In the method for analyzing deformation of a casting in a die casting process according to the embodiment described above, the frictional coefficient function based on the casting conditions and the lubrication conditions is used, and this frictional coefficient function has the contact surface pressure and the contact surface temperature as input variables. Thus, the fixed die frictional stress F exerted by the fixed die 1 on a predetermined portion of the casting P1, i.e., the mold opening resistance due to the contact surface pressure of the fixed die 1, can be analyzed using the value of the frictional coefficient according to the casting conditions, the lubrication conditions, the contact surface pressure, and the contact surface temperature. Therefore, the result of an analysis of casting deformation agrees well with the result of a test of casting deformation after ejection and release from a mold in a die casting process, so that the accuracy of the analysis of casting deformation can be improved.

In the method for analyzing deformation of a casting in a die casting process according to the embodiment described above, as the coefficient of friction between the casting P1 and the fixed die 1, the static frictional coefficient $\mu0$ is used at time point T0 at which mold opening is started, and the dynamic frictional coefficient $\mu l$ is used from time point T1 at which the movable die 2 is separated from the fixed die 1 after the start of mold opening until time point T2 at which the casting P1 is separated from the fixed die 1. Thus, the mold opening resistance due to the contact surface pressure of the fixed die 1 can be analyzed using the frictional coefficient according to the time point in mold opening. Therefore, the accuracy of an analysis of casting deformation can be further improved.

In the method for analyzing deformation of a casting in a die casting process according to the embodiment described above, the time for which the fixed die frictional stress F is exerted on the casting P1 while the movable die 2 is moving and the magnitude of this fixed die frictional stress F may be obtained by varying material properties, mainly the modulus of elasticity, based on the temperatures of the movable die 2 in motion, the fixed die 1, and the casting P1. The mold opening resistance due to the contact surface pressure of the fixed die 1 can be analyzed using the moduli of elasticity E1, E2 according to the temperatures of the fixed die 1 and the casting P1. As described above, the moduli of elasticity E1, E2 significantly affect the amounts of elastic deformation L1, L2. When the amounts of elastic deformation L1, L2 are large, a large fixed die frictional stress F tends to act on the casting P1 for a prolonged time. The moduli of elasticity E1, E2 according to the temperatures of the fixed die 1 and the casting P1 are considered as values closer to the actual phenomenon of casting deformation. Therefore, the accuracy of an analysis of casting deformation can be further improved.

In the method for analyzing deformation of a casting in a die casting process according to the embodiment described above, casting deformation after mold opening due to mold release resistance caused by the ejector pins 21 can be obtained based on the deformation of the casting P1 due to the fixed die frictional stress F, the deformation of the casting P1 inside the mold (see FIG. 2), and the amount of deformation due to release of residual stress (see FIG. 2). Therefore, the accuracy of an analysis of casting deformation can be further improved.

The present invention is not limited to the above embodiment but can be modified as appropriate within the scope of the appended claims.

**Claims**

1. An analysis method for analyzing deformation of a casting (P1) in a die casting process,
   the die casting process including:

   a step of closing a mold by pressing a second die (2) against a first die (1), and injecting molten metal into cavities (C1, C2) of the first die (1) and the second die (2) and solidifying the molten metal to form the casting (P1) inside the cavities (C1, C2); and
   a mold opening step of opening the mold by separating the second die (2) from the first die (1) with the casting (P1) held in the second die (2),

   the analysis method comprising:

   obtaining a first die frictional stress exerted by the first die (1) on the casting (P1) in the mold opening step; and
   calculating deformation of the casting (P1) in the mold opening step using the first die frictional stress wherein a predetermined frictional coefficient function from a plurality of different frictional coefficient functions based on casting conditions and lubrication conditions is selected, and a frictional coefficient at each portion of the casting (P1) is output by inputting a temperature of a contact surface between the casting (P1) and the first die (1) and a contact surface pressure between the casting (P1) and the first die (1) into the predetermined frictional coefficient function, and then the first die frictional stress acting on each portion of the casting (P1) is calculated by multiplying the contact surface pressure exerted by the casting (P1) on the first die (1) and the frictional coefficient.

2. The analysis method according to claim 1, wherein
   in the mold opening step, the frictional coefficient is a static frictional coefficient from a time point (T0) at which the mold opening is started until immediately before a time point (T1) at which the second die (2) is separated from the first die (1), and
   the frictional coefficient is a dynamic frictional coefficient from the time point (T1) at which the second die (2) and the first die (1) are separated from each other until a time point (T2) at which the casting (P1) is separated from the second die (2).

3. The analysis method according to claim 1 or 2, wherein
   an amount of movement that the casting (P1) moves in the mold opening step from a time point (T0) at which the mold opening is started until a time point (T2) at which the casting (P1) is separated from the second die (2) is obtained based on a draft of the first die (1) and amounts of elastic deformation of the first die (1) and the casting (PI), and
   the amounts of elastic deformation of the first die (1) and the casting (P1) are obtained using moduli of elasticity of the first die (1) and the casting (P1), the moduli of elasticity of the first die (1) varying with a temperature of the first die, the moduli of elasticity of the casting (P1) varying with a temperature of the casting (P1).

4. The analysis method according to any one of claims 1 to 3, wherein
the die casting process further includes a mold releasing step of releasing the casting (P1) from the second die (2) after the mold opening step, and
the analysis method further comprises obtaining a second die frictional stress exerted by the second die (2) on the casting (P1) when an ejector pin (21) is thrust out of the cavity (C2) of the second die (2) in the mold releasing step, and calculating deformation of the casting (P1) in the mold releasing step using the second die frictional stress.

# FIG. 1

```
        ┌─────────────┐
        │    START    │
        └─────────────┘
               │
               ▼
   ┌───────────────────────┐
   │  MELT FLOW CALCULATION │ ～ ST1
   └───────────────────────┘
               │
               ▼
   ┌───────────────────────┐
   │   MOLD TEMPERATURE     │ ～ ST2
   │ DISTRIBUTION CALCULATION│
   └───────────────────────┘
               │
               ▼
   ┌───────────────────────┐
   │    SOLIDIFICATION      │ ～ ST3
   │  SHRINKAGE CALCULATION │
   └───────────────────────┘
               │
               ▼
   ┌───────────────────────┐
   │   AIR GAP CALCULATION  │ ～ ST4
   └───────────────────────┘
               │
               ▼
   ┌───────────────────────┐
   │   CONTACT SURFACE      │ ～ ST5
   │  PRESSURE CALCULATION  │
   └───────────────────────┘
               │
               ▼
   ┌───────────────────────┐
   │POST-MOLD OPENING CASTING│ ～ ST6
   │ DEFORMATION CALCULATION │
   └───────────────────────┘
               │
               ▼
        ┌─────────────┐
        │     END     │
        └─────────────┘
```

# FIG. 2

START

MELT FLOW CALCULATION — ST1

MOLD TEMPERATURE DISTRIBUTION CALCULATION — ST2

SOLIDIFICATION SHRINKAGE CALCULATION — ST3

AIR GAP CALCULATION — ST4

CONTACT SURFACE PRESSURE CALCULATION — ST5

POST-MOLD OPENING CASTING DEFORMATION CALCULATION — ST6

END

TIME POINT AT WHICH HEAT CONDUCTION CHANGES TO HEAT TRANSFER

CHANGES IN PRODUCT COOLING CONDITIONS

CHANGES IN PRODUCT TEMPERATURE DISTRIBUTION

CHANGES IN PRODUCT STRENGTH DISTRIBUTION

CHANGES IN MOLD TEMPERATURE DISTRIBUTION

CHANGES IN PRODUCT RESIDUAL STRESS

CHANGES IN CONTACT SURFACE PRESSURE

CHANGES IN FRICTIONAL COEFFICIENT

CALCULATION OF DEFORMATION DURING MOLD OPENING

ITEMS REQUIRED FOR CASTING DEFORMATION CALCULATION

CASTING DEFORMATION INSIDE MOLD

DEFORMATION DUE TO RELEASE OF RESIDUAL STRESS

MOLD OPENING RESISTANCE DUE TO CONTACT SURFACE PRESSURE (MOVABLE AND FIXED DIES)

RESISTANCE DUE TO EJECTION (MOVABLE DIE)

EP 3 354 374 A1

# FIG. 3

EP 3 354 374 A1

# FIG. 4

|  |  | CASTING CONDITIONS | | |  |
|---|---|---|---|---|---|
|  |  | (1)<br>M/T CASE | (2)<br>A/T CASE | (3) O/P<br>(OIL PAN) |  |
| LUBRICATION CONDITIONS | (1) BASE LUBRICATION A | CONDITIONS (1) (1) | CONDITIONS (2) (1) | CONDITIONS (3) (1) |  |
|  | (2) M/T CASE LUBRICATION A REVISED | CONDITIONS (1) (2) | — | CONDITIONS (3) (2) |  |
|  | (3) A/T CASE LUBRICATION CC | — | CONDITIONS (2) (3) | — |  |
|  | ⋮ |  |  |  |  |

# FIG. 5

FRICTIONAL
COEFFICIENT $\mu$

CONDITIONS (1) (1)

CL1

CL2

CL3

CONTACT SURFACE
PRESSURE N

CONTACT SURFACE
TEMPERATURE Temp [°C]

# FIG. 6

AL CASTING

P1

CONTACT SURFACE
PRESSURE: N

REACTIVE
FORCE: Nr

1

FIXED DIE

TIME T: T0

# FIG. 7

$$L1 = E1(T) \times N / S$$

$$L2 = E2(T) \times N / S$$

P1

1

θ

Lmove

L2

L1

TIME T: T1-T2

# FIG. 8

Lmove1

P1

1

TIME T: T2

# FIG. 9

FRICTIONAL STRESS F
CONTACT SURFACE PRESSURE N

$F0: (= \mu0 \times N0)$

$F: (= \mu1 \times N)$

N: DECREASE IN N CORRESPONDING TO RESTORATION OF ELASTIC DEFORMATION

FRICTIONAL COEFFICIENT $\mu$

$\mu0$ (STATIC FRICTIONAL COEFFICIENT)

$\mu1$ (DYNAMIC FRICTIONAL COEFFICIENT)

AMOUNT OF MOVEMENT Lmove

Lmove1

TIME T

Europäisches
Patentamt

European
Patent Office

Office européen
des brevets

# EUROPEAN SEARCH REPORT

Application Number

EP 18 15 3493

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2010/127772 A2 (MAGMA GIESSEREITECHNOLOGIE GMB [DE]; HEITZER MICHAEL [DE]; KLINKHAMMER) 11 November 2010 (2010-11-11) * figures 2C, 10, 15-17 * * claims 1-3, 8-10, 15, 16 * * paragraph [0002] * * paragraphs [0038] - [0040] * * paragraph [0077] - paragraph [0080] * * paragraph [0090] - paragraph [0094] * * paragraph [0104] - paragraph [0120] * * paragraph [0132] * ----- | 1-4 | INV. B22D17/32 B22D17/10 B22D17/22 |

TECHNICAL FIELDS
SEARCHED (IPC)

B22D

The present search report has been drawn up for all claims

| Place of search | Date of completion of the search | Examiner |
|---|---|---|
| The Hague | 16 March 2018 | Porté, Olivier |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

&  : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 15 3493

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2018

| Patent document cited in search report | Publication date | Patent family member(s) | Publication date |
|---|---|---|---|
| WO 2010127772 A2 | 11-11-2010 | BR PI1011294 A2 | 25-10-2016 |
|  |  | CN 102395972 A | 28-03-2012 |
|  |  | EP 2427835 A2 | 14-03-2012 |
|  |  | JP 2012520193 A | 06-09-2012 |
|  |  | KR 20110129387 A | 01-12-2011 |
|  |  | US 2012035891 A1 | 09-02-2012 |
|  |  | WO 2010127772 A2 | 11-11-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7009522 A